(19) Europäisches Patentamt
European Patent Office
Office européen des brevets

(11) Veröffentlichungsnummer: **0 413 216 A2**

# (12) EUROPÄISCHE PATENTANMELDUNG

(21) Anmeldenummer: **90114911.2**

(51) Int. Cl.[5]: **G03F 7/085**, G03F 7/027

(22) Anmeldetag: **03.08.90**

(30) Priorität: **12.08.89 DE 3926708**

(43) Veröffentlichungstag der Anmeldung:
**20.02.91 Patentblatt 91/08**

(84) Benannte Vertragsstaaten:
**BE DE FR GB IT NL**

(71) Anmelder: **BASF Aktiengesellschaft**
**Carl-Bosch-Strasse 38**
**D-6700 Ludwigshafen(DE)**

(72) Erfinder: **Seitz, Friedrich, Dr.**
**Von-Wieser-Strasse 1**
**D-6701 Friedelsheim(DE)**
Erfinder: **Hoffmann, Gerhard, Dr.**
**Pappelstrasse 22**
**D-6701 Otterstadt(DE)**
Erfinder: **Bauer, Gerhard, Dr.**
**Uhlandstrasse 16**
**D-6940 Weinheim(DE)**

## (54) Photopolymerisierbares Schichtübertragungsmaterial.

(57) Diese photopolymerisierbaren Schichtübertragungsmaterialien bestehen aus mindestens einem filmbildenden Polymerisat als Bindemittel, mindestens einer mit dem Bindemittel verträglichen organischen Verbindung mit mindestens zwei zur Additionspolymerisation befähigten Doppelbindungen, die gegebenenfalls teilsweise durch eine organische Verbindung mit nur einer zur Additionspolymerisation befähigten Doppelbindung ersetzt sein kann, einem Photoinitiator oder Photoinitiatorsystem, einem Haftungsvermittler und gegebenenfalls üblichen Zusatz- und Hilfsstoffen, wobei als Haftungsvermittler eine tricyclische heteroaromatischen Verbindung, die in wäßrig-alkalischer Lösung löslich ist, eingesetzt wird.

Diese photopolymerisierbaren Schichtübertragungsmaterialien eignen sich zur Herstellung gedruckter Schaltungen.

EP 0 413 216 A2

Xerox Copy Centre

# PHOTOPOLYMERISIERBARES SCHICHTÜBERTRAGUNGSMATERIAL

Die Erfindung betrifft ein photopolymerisierbares Schichtübertragungsmaterial, das verbesserte Haftung in wäßrigen Plattier- und Ätzbädern aufweist, insbesondere einen in wäßrig-alkalischen Entwicklerlösungen entwickelbaren Photoresistfilm zur Herstellung gedruckter Schaltungen.

Gedruckte Schaltungen können hergestellt werden, indem ein photoempfindliches Schichtübertragungsmaterial unter Anwendung von Temperatur und Druck von einem temporären Träger auf ein metallisches Substrat, vorzugsweise mit Kupfer kaschiertes Epoxidharzmaterial, übertragen wird. Nach Belichtung der photoempfindlichen Schicht durch eine bildmäßige Vorlage werden, im Fall von Negativresisten, die unbelichteteten Bereiche mit einer Entwicklerlösung entfernt. Bei wäprig-alkalisch entwickelbaren Schichtübertragungsmaterialien dient als Entwicklerlösung meist eine wäßrige Sodalösung. Die freiliegende Metalloberfläche kann dann permanent modifiziert werden, z.B. durch galvanische Metallabscheidung. Bei schlechter Haftung zwischen Schichtübertragungsmaterial und Metalloberfläche kommt es dabei zu einer Unterwanderung des Schichtübertragungsmaterials durch die Plattierlösung und zu einer Metallabscheidung auch an den Stellen, an denen eine solche unerwünscht ist. Dadurch wird eine Kantenunschärfe bewirkt, in extremen Fällen kann es zu Kurzschlüssen zwischen benachbarten Leiterbahnen kommen.

zur Lösung dieses Problems wurde vorgeschlagen, dem Schichtübertragungsmaterial geeignete Haftungsverbesserer zuzusetzen. Als solche Haftungsverbesserer wurden z.B. Benztriazol (DE-A-2063571, US-A-3645772) und eine Reihe seiner Derivate (DE-A-3600442, EP-A-247549, US-A-4680249, US-A-4710262, JP 61223836, JP 62278541) erwähnt. Die durch diese Verbindungen erzeugte Haftungsverbesserung reicht jedoch in vielen Fällen nicht aus.

Die bisher als Haftungsverbesserer verwendeten Triazolverbindungen weisen einen erheblichen Nachteil auf, insbesondere wenn sie in wäßrig-alkalisch entwickelbaren Photoresistfilmen eingesetzt werden: Werden die Leiterplatten während des Herstellungsprozesses zwischen Laminieren und Entwickeln einige Tage bis Wochen gelagert, kommt es, insbesondere bei Temperaturen über der normalen Raumtemperatur und hoher Luftfeuchtigkeit, an der Metalloberfläche zur Ausbildung einer gegen die Entwicklerlösung resistenten Schicht (im folgenden als Restschicht bezeichnet), die eine weitere Verarbeitung der Platten unmöglich macht. Dieses Problem ist bei allen wäßrig-alkalisch entwickelbaren Schichtübertragungsmaterialien latent vorhanden.

Überraschenderweise gelingt es, die Haftung zwischen Metall und Schichtübertragungsmaterial erheblich zu verbessern und gleichzeitig die Ausbildung von Restschicht vollständig zu verhindern, wenn als Haftvermittler alkalilösliche, tricyclische heteroaromatische Verbindungen verwendet werden.

Gegenstand der vorliegenden Erfindung ist ein photopolymerisierbares Schichtübertragungsmaterial, bestehend aus

(a) mindestens einem filmbildenden Polymerisat als Bindemittel,

(b) mindestens einer mit dem Bindemittel verträglichen organischen Verbindung mit mindestens zwei zur Additionspolymerisation befähigten Doppelbindungen, die gegebenenfalls teilweise durch eine organische Verbindung mit nur einer zur Additionspolymerisation befähigten Doppelbindung ersetzt sein kann,

(c) einem Photoinitiator oder Photoinitiatorsystem,

(d) einem Haftungsvermittler und

(e) gegebenenfalls üblichen zusatz- und Hilfsstoffen, das dadurch gekennzeichnet ist, daß als Haftungsvermittler (d) eine tricyclische heteroaromatische Verbindung, die in wäßrig-alkalischer Lösung löslich ist, eingesetzt wird.

Insbesondere handelt es sich um ein Schichtübertragungsmaterial, das in wäßrig-alkalischen Lösungen, z.B. in wäßriger Natriumcarbonatlösung, entwickelt werden kann.

Als erfindungsgemäß einzusetzende Verbindungen (d) eignen sich solche, die in wäßrig-alkalischer Lösung löslich sind. Ein geeignetes Kriterium ist die Löslichkeit in einer wäßrigen Lösung, die auf 100 Gew.-Teile Lösung 1 Gew.-Teil Natriumcarbonat enthält. Für die Verwendung in den erfindungsgemäßen photopolymerisierbaren Schichtübertragungsmaterialien sind vor allem solche Verbindungen geeignet, deren Löslichkeit in der oben beschriebenen 1 %igen Natriumcarbonatlösung bei 25 °C mindestens 0,05 Gew.-% beträgt. Bevorzugt werden Verbindungen, die unter den angegebenen Bedingungen eine Löslichkeit von mindestens 0,1 Gew.-%, besonders bevorzugt solche, die eine Löslichkeit von mindestens 0,2 Gew.-% aufweisen.

Die als Haftungsvermittler (d) geeigneten tricyclischen heteroaromatischen Verbindungen weisen vorzugsweise eine Struktur der allgemeinen Formel (I)

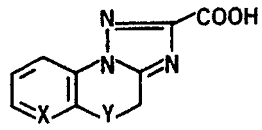

(I)

auf, worin X für CH oder N, Y für O, S oder $NR^1$ und $R^1$ für H, Alkyl, beispielsweise mit 1 bis 6 Kohlenstoffatomen, wie Methyl, Ethyl, Propyl, Butyl, Cyclohexyl oder Aryl, z.B. Phenyl stehen.

Diese Verbindungen können beispielsweise nach den Herstellvorschriften in Helv. Chim. Acta 70 (1987), 2118-29, synthetisiert werden.

Beispiele für besonders bevorzugte erfindungsgemäße Haftungsvermittler (d) sind solche der Formeln (II) und (III)

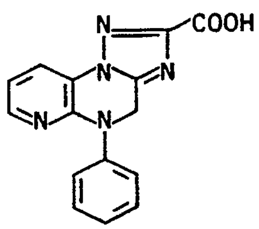

und

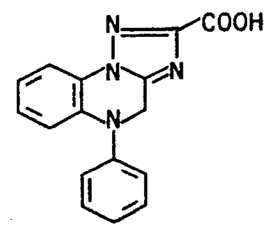

(II) (III)

Die als Haftungsvermittler verwendeten tricyclischen heteroromatischen Verbindungen (d) sind in den erfindungsgemäßen Schichtübertragungsmaterialien im allgemeinen in einer Konzentration von 0,01 bis 5 Gew.-% bevorzugt von 0,1 bis 2 Gew.-% und besonders bevorzugt von 0,2 bis 1 Gew.-%, bezogen auf das Gesamtgewicht des photopolymerisierbaren Schichtübertragungsmaterials, enthalten. Es ist auch möglich und in einzelnen Fällen vorteilhaft, Gemische der erfindungsgemäß zu verwendenden Verbindungen einzusetzen.

zu den anderen Aufbaukomponenten des erfindungsgemäßen Schichtübertragungsmaterials ist im einzelnen folgendes auszuführen.

(a) Als für die Verwendung als Bindemittel geeignete filmbildende polymerisate (a) kommen in Wasser unlösliche, in wäßrig-alkalischen Lösungen jedoch lösliche oder zumindest dispergierbare polymere Bindemittel, insbesondere carboxylgruppenhaltige oder Carbonsäureanhydrid-Gruppen enthaltende Copolymerisate in Betracht, wie z.B. Styrol/Maleinsäureanhydrid-Copolymerisate, Styrol/Maleinsäure halbester-Copolymerisate, Alkyl(meth)acrylat/(Meth)acrylsäure-Copolymerisate, Copolymerisate aus Styrol, Alkyl(meth)-acrylaten und (Meth)acrylsäure sowie gegebenenfalls anderen Monomeren (vgl. u.a. DE-B-20 27 467, DE-A-22 05 146, EP-A-49 504 oder DE-A-27 36 058) oder Copolymerisate, die Acrylsäure und/oder Methacrylsäure, hydrophobe Comonomere und N-Vinylamide einpolymerisiert enthalten, wie sie beispielsweise in DE-A-34 47 356 beschrieben sind. Derartige Copolymerisate können beispielsweise 10 bis 50 Gew.% eines Vinylamids, wie z.B. N-Vinylformamid, N-Vinylacetamid, N-Vinyl-N-Methylacetamid oder N-Vinyllactame, wie N-Vinylpyrrolidon und/oder N-Vinylcaprolactam, 5 bis 30 Gew.% Acrylsäure und/oder Methacrylsäure sowie 30 bis 80 Gew.% mindestens eines hydrophoben Comonomeren, welches als solches in Wasser und wäßrig-alkalischen Lösungen unlösliche Homopolymerisate bildet, einpolymerisiert enthalten.

Als Beispiele für die letztgenannten hydrophoben Comonomeren seien genannt: Vinylaromaten, wie z.B. Styrol, substituierte Styrole, die in der Seitenkette oder im Kern beispielsweise durch Alkylgruppen oder Halogenatome substituiert sind, wie α-Methylstyrol, p-Methylstyrol und dergleichen, Vinylacetat sowie die Ester der Acrylsäure und Methacrylsäure, insbesondere die Acrylate und Methacrylate von geradkettigen oder verzweigten Monoalkanolen, vorzugsweise mit 1 bis 4 C-Atomen, wobei hierunter unter anderem das Methylmethacrylat besonders günstig ist. Das Copolymerisat kann ein oder mehrere der hydrophoben Comonomeren einpolymerisiert enthalten, wobei der Anteil der hydrophoben Comonomer-Einheiten in dem Copolymerisat 30 bis 80 Gew.% vorzugsweise 40 bis 70 Gew.%, bezogen auf das Copolymerisat, betragen kann.

Beispiele für Copolymerisate für den Einsatz als polymeres Bindemittel in den lichtempfindlichen Schichtübertragungsmaterialien sind u.a. N-Vinyllactam/(Meth)acrylsäure/Methylmethacrylat-Copolymerisate oder N-Vinyllactam/(Meth)acrylsäure/Styrol-Copolymerisate. In einer typischen Ausführungsform können diese Copolymerisate die Comonomeren beispielsweise in Mengen von 25 bis 35 Gew.% an N-Vinylcaprolactam und/oder N-Vinylpyrrolidon, 5 bis 15 Gew.% an (Meth)acrylsäure und 55 bis 65 Gew.% an

hydrophoben Comonomeren, jeweils bezogen auf das Copolymerisat, einpolymerisiert enthalten.

Beispiele für weitere geeignete polymere Bindemittel (a) sind Styrol(Meth)-acrylsäure/Methylmethacrylat/Ethylacrylat-Copolymerisate, die z.B. 10 bis 40 % Styrol, 20 bis 30 % Methacrylsäure, 5 bis 50 % Methylmethacrylat und 0 bis 50 % Ethylacrylat einpolymerisiert enthalten.

Die Comonomeren für die einzusetzenden Copolymerisate (a) werden nach Art und Menge in dem vorstehend angegebenen allgemeinen Rahmen so ausgewählt, daß die Copolymerisate filmbildend sind und die an sie gestellten Forderungen bezüglich ihrer Löslichkeit bzw. Dispergierbarkeit erfüllen. Gegebenenfalls können auch Gemische geeigneter carboxylgruppenhaltiger Copolymerisate eingesetzt werden.

Die als polymeres Bindemittel einzusetzenden Copolymerisate können nach den an sich bekannten und üblichen Polymerisationsmethoden durch Copolymerisation der Comonomeren, beispielsweise in Lösung, hergestellt werden. Für die Lösungspolymerisation eignen sich z.B. niedere Alkanole, Ketone, Ester und ähnliche, wie Methanol, Aceton, Methylethylketon, Ethylacetat etc., als Lösungsmittel. Als Polymerisationsinitiatoren kommen die üblichen radikalischen Starter, wie beispielsweise Azobisisobutyronitril, Benzoylperoxid und dergleichen in Betracht.

Die als Bindemittel verwendeten filmbildenden Polymerisate (a) sind in dem photopolymerisierbaren Schichtübertragungsmaterial im allgemeinen in einer Menge von 40 bis 90 Gew.-%, vorzugsweise von 50 bis 70 Gew.-%, bezogen auf das Gesamtgewicht des photopolymerisierbaren Schichtübertragungsmaterials, enthalten.

(b) Als organische Verbindungen (b) mit mindestens zwei zur Additionspolymerisation befähigten Doppelbindungen können die üblichen photopolymerisierbaren Monomeren verwendet werden, bevorzugt solche mit Siedepunkten über 100 °C und Molekulargewichten < 1000.

Als Vertreter für die photopolymerisierbaren Monomeren seien insbesondere die Derivate der (Meth)-acrylsäure und ganz besonders die (Meth)acrylsäureester genannt. Beispiele hierfür sind die Di- und Tri-(meth)acrylate von Ethylenglykol, Diethylenglykol, Triethylenglykol oder Polyethylenglykolen mit einem Molekulargewicht bis etwa 500, 1,2-Propandiol, 1,3-Propandiol, Polypropylenglykolen mit einem Molekulargewicht bis etwa 500, 1,4-Butandiol, 1,1,1-Trimethylolpropan, 2,2-Dimethylpropandiol, Glycerin oder Pentaerythrit; z.B. Pentaerythrittetra(meth)acrylat, Glucosetri- oder tetra-(meth)acrylat. Die mit dem Bindemittel verträglichen organischen Verbindungen mit mindesens zwei zur Additionspolymerisation befähigten Doppelbindungen können gegebenenfalls teilweise, im allgemeinen in untergeordneten Mengen von bis zu etwa 30 Gew.-% der Gesamtmenge der Komponente (b), durch organische Verbindungen mit nur einer zur Additionspolymerisation befähigten Doppelbindung ersetzt sein. Als solche eignen sich beispielsweise die Monoacrylate und Monomethacrylate der genannten Diole und Polyole, wie z.B. Ethylenglykol-, Di-, Tri-oder Tetraethylenglykolmono(meth)acrylat, Propandiol-mono(meth)acrylat und Butandiol-mono(meth)acrylat und die (Meth)acrylate von Monoalkanolen, insbesondere von solchen mit 1 bis 20 C-Atomen. Neben den bevorzugten Acrylaten und Methacrylaten der vorstehend genannten Art seien als photopolymerisierbare Monomere auch die Allyl-Verbindungen und andere Vinyl-Verbindungen genannt, wie z.B. N-Vinylpyrrolidon, N-Vinylcaprolactam, Vinylacetat, Vinylpropionat, (Meth)acrylamid, N-Methylol-(meth)acrylamid, der Bisether des Ethylenglykols und N-Methylol-(meth)acrylamids, Vinylcarbamate und Bisacrylamidoessigsäure.

Geeignete ethylenisch ungesättigte, photopolymerisierbare Verbindungen für die erfindungsgemäßen lichtempfindlichen Aufzeichnungsschichten sind auch die monomeren Urethanacrylate bzw. -methacrylate mit zwei oder mehr Acryloyl- und/oder Methacryloyl-Gruppen. Solche monomeren Urethan(meth)acrylate können beispielsweise erhalten werden durch Umsetzung von aliphatischen Di- oder Polyolen mit organischen Diisocyanaten in einem Äquivalentverhältnis OH:NCO von etwa 1:2 und anschließende Umsetzung der freien Isocyanatgruppen des erhaltenen Reaktionsproduktes mit geeigneten Acryloyl- und/oder Methacryloyl-Verbindungen, beispielsweise Hydroxyalkyl-(meth)acrylaten. Als aliphatische Di- oder Polyole kommen unter anderem die vorstehend im zusammenhang mit den Di- und Tri(meth)acrylaten genannten Di- und Polyhydroxy-Verbindungen in Betracht; als Beispiele für organische Diisocyanate seien Hexamethylendiisocyanat, Toluylendiisocyanat, Isophorondiisocyanat und ähnliche genannt; Hydroxyalkyl(meth)acrylate sind beispielsweise Hydroxyethyl-(meth)acrylat, Propandiol-mono(meth)acrylat oder Butandiol-mono(meth)-acrylat. Ebenso geeignet und vorteilhaft sind Monomere mit zwei oder mehr Acryloyl- und/oder Methacryloyl-Gruppen, wie sie beispielsweise erhalten werden können durch Umsetzung von Di- oder Polyglycidylverbindungen mit Acrylsäure und/oder Methacrylsäure. Als Di- und Polyglycidylverbindungen kommen hier insbesondere die Di- und Polyglycidylether mehrwertiger Phenole, beispielsweise des Bisphenols A oder der Substitutionsprodukte von Bisphenol A, in Betracht. Beispielhaft für solche Acryloyl- und/oder Methacryloyl-Gruppen enthaltenden Monomeren seien die Umsetzungsprodukte des Bisphenol A-bisglycidylethers mit Acryl- und/oder Methacrylsäure im molaren Verhältnis von etwa 1:2 hervorgehoben.

Die Verbindungen (b) mit mindestens zwei zur Additionspolymerisation befähigten Doppelbindungen die

gegebenenfalls teilweise durch eine organische Verbindung mit nur einer zur Additionspolymerisation befähigten Doppelbindung ersetzt sein kann, werden zweckmäßigerweise so gewählt, daß sie mit den als Bindemittel verwendeten filmbildenden Polymerisaten (a) verträglich sind. Im allgemeinen sind die photopolymerisierbaren Monomeren in einer Konzentration von 10 bis 60 Gew.-%, bevorzugt von 20 bis 40 Gew.-%, bezogen auf das Gesamtgewicht des photopolymerisierbaren Schichtübertragungsmaterials, enthalten.

(c) Als Photoinitiatoren oder Photoinitiatorsysteme (c) für die photopolymerisierbaren Schichtübertragungsmaterialien kommen die für lichtempfindliche, photopolymerisierbare Aufzeichnungsmaterialien üblichen und an sich bekannten Photoinitiatoren bzw. Photoinitiatorsysteme in Betracht. Beispielhaft seien hierfür genannt: Benzoin, Benzoinether, insbesondere Benzoinalkylether, substituierte Benzoine, Alkylether von substituierten Benzoinen, wie z.B. α-Methylbenzoinalkylether oder α-Hydroxymethylbenzoinalkylether; Benzile, Benzilketale, insbesondere Benzildimethylketal, Benzilmethylethylketal oder Benzilmethylbenzylketal; die als Photoinitiator bekannten und wirksamen Acylphosphinoxid-Verbindungen, wie z.B. 2,4,6-Trimethylbenzoyldiarylphosphinoxid; Benzophenon, Derivate des Benzophenons, 4,4′-Dimethylaminobenzophenon, Derivate von Michler's Keton; Anthrachinon und substituierte Anthrachinone; arylsubstituierte Imidazole oder deren Derivate, wie z.B. 2,4,5-Triarylimidazoldimere; Thioxanthonderivate und die als Photoinitiatoren wirksamen Acridin- oder Phenacin-Derivate. Beispiele für Initiatorsysteme sind Kombinationen der genannten Initiatoren mit Sensibilisierungshilfsmitteln oder Aktivatoren, wie insbesondere tertiären Aminen.

Typische Beispiele für solche Initiatorsysteme sind Kombinationen aus Benzophenon oder Benzophenonderivaten mit tertitären Aminen, z.B. Michlers Keton, Triethanolamin oder Dimethylaminobenzoesäureethylester, oder Gemische aus einem Thioxanthonderivat, einem tertiären Amin oder einem Hexaarylbisimidazol-Derivat. Die Photoinitiatoren oder photoinitiatorsysteme (c) sind in dem photopolymerisierbaren Schichtübertragungsmaterial in einer Menge von 0,01 bis 10 Gew.-%, bevorzugt von 0,5 bis 5 Gew.-% enthalten.

(e) Als weitere gegebenenfalls mitzuverwendende Zusatz- und Hilfsstoffe (e), die in dem erfindungsgemäßen photopolymerisierbaren Schichtübertragungsmaterial enthalten sein können, kommen z.B. Inhibitoren gegen die thermische Polymerisation, Farbstoffe und/oder Pigmente, photochrome Verbindungen bzw. Systeme, sensitometrische Regler, Weichmacher, Verlaufshilfsmittel, Mattierungs- oder Gleitmittel und dergleichen in Betracht. Geeignete Polymerisationsinhibitoren sind z.B. Hydrochinon, Hydrochinon-Derivate, 2,6-Di-t.-butyl-p-cresol, Nitrophenole, N-Nitrosoamine, wie N-Nitrosodi phenylamin oder die Salze des N-Nitrosocyclohexylhydroxylamins. Beispiele für Farbstoffe und/oder Pigmente, die sowohl als Kontrastmittel als auch schichtverfestigend wirken können, sind u.a. Brilliant Green Dye (C.I. 42 040), Viktoria-Reinblau FGA, Viktoria-Reinblau BO (C.I. 42 595), Viktoria-Blau B (C.I. 44 045), Rhodamin 6 G (C.I. 45 160), Triphenylmethanfarbstoffe, Naphthalimidfarbstoffe und 3′-Phenyl-7-dimethylamino-2,2′-spiro-di-(2H-1-benzopyran). Photochrome Systeme, die bei Belichtung mit aktinischem Licht reversibel oder irreversibel ihre Farbe ändern, ohne hierbei den Photopolymerisationsprozeß zu stören, sind z.B. Leukofarbstoffe zusammen mit geeigneten Aktivatoren. Als Beispiele für Leukofarbstoffe seien die Leukobasen der Triphenylmethanfarbstoffe, wie Kristallviolett-Leukobase und Malachitgrün-Leukobase, Leuko-Basischblau, Leuko-Pararosanilin, Leuko-Patentblau A oder V genannt; ferner kommt auch Rhodamin B-Base in Betracht. Als Aktivatoren für diese photochromen Verbindungen kommen u.a. organische Halogenverbindungen, die bei Belichtung mit aktinischem Licht Halogenradikale abspalten, oder Hexaarylbisimidazole in Betracht. Zu den sensitometrischen Reglern gehören Verbindungen wie z.B. 9-Nitroanthracen, 10,10′-Bisanthron, Phenazinium-, Phenoxazinium-, Acridinium- oder Phenothiazinium-Farbstoffe, insbesondere in Kombination mit milden Reduktionsmitteln wie Thioharnstoff, Anethol, Salzen des N-Nitrosocyclohexylhydroxylamins, 1,3-Dinitrobenzole und ähnliche. Als Weichmacher können die an sich bekannten und üblichen niedermolekularen oder hochmolekularen Ester, wie Phthalate oder Adipate, Toluolsulfonamid oder Tricresylphosphat, dienen. Die Zusatz- und/oder Hilfsstoffe sind in den photopolymerisierbaren Schichtübertragungsmaterialien in den für diese Stoffe üblichen und bekannten wirksamen Mengen vorhanden. Ihre Menge sollte jedoch im allgemeinen 30 Gew.%, vorzugsweise 20 Gew.%, bezogen auf photopolymerisierbares Schichtübertragungsmaterial nicht überschreiten.

Das Mischungsverhältnis, in dem die einzelnen Komponenten im photopolymerisierbaren Schichtübertragungsmaterial enthalten sind, wird im allgemeinen so gewählt, daß das Schichtübertragungsmaterial nicht nur wäßrig-alkalisch entwickelbar, sondern vorteilhafterweise auch bei Raumtemperatur fest und nicht klebrig ist und gute Filmbildungseigenschaften besitzt. Für den Einsatz der erfindungsgemäßen lichtempfindlichen Schichtübertragungsmaterialien als Photoresistfilm wird die zusammensetzung darüber hinaus so gewählt, daß die lichtempfindliche Aufzeichnungsschicht gut laminierbar und unter Anwendung von Druck sowie gegebenenfalls Wärme auf ein Substrat übertragbar ist. Für die Herstellung von Resistmustern werden üblicherweise Schichtdicken der lichtempfindlichen Aufzeichnungsschicht im Bereich von etwa 1 bis

50 µm eingestellt.

Für Schichtübertragungsmaterialien finden als Trägermaterialien vorzugsweise Kunststoff-Filme oder -Folien, insbesondere Polyester-Folien, Verwendung, die eine mäßige Haftung zu der lichtempfindlichen Aufzeichnungsschicht haben und nach dem Auflaminieren bzw. Aufkaschieren der photopolymerisierbaren Aufzeichnungsschicht auf ein Substrat von dieser - vor oder nach der Belichtung mit aktinischem Licht - abgezogen werden können.

Die dem Träger abgewandte Seite des erfindungsgemäßen photopolymerisierbaren Schichtübertragungsmaterials kann mit einer Deckfolie, z.B. aus Polyolefinen, wie Polyethylen oder Polypropylen, abgedeckt werden.

Die Herstellung des erfindungsgemäßen photopolymerisierbaren Schichtübertragungsmaterials kann in an sich bekannter und üblicher Weise durch Herstellung einer homogenen Mischung der das photopolymerisierbare Schichtübertragungsmaterial bildenden Komponenten und schichtförmiges Aufbringen dieser Mischung auf den - gegebenenfalls mit einer Zwischenschicht versehenen - Träger erfolgen. Beispielsweise kann man die Komponenten des photopolymerisierbaren Schichtübertragungsmaterials rein mechanisch in einer geeigneten Mischvorrichtung, z.B. einem Mischer oder Extruder, homogen vermischen und diese Mischung, beispielsweise durch Extrudieren, Kalandrieren oder Pressen, zu einer Schicht der gewünschten Dicke formen, die dann auf den Träger auflaminiert bzw. aufkaschiert wird. Vorzugsweise werden die photopolymerisierbaren Schichtübertragungsmaterialien jedoch hergestellt, indem man die Komponenten des photopolymerisierbaren Schichtübertragungsmaterials in einem geeigneten Lösungsmittel oder Lösungsmittelgemisch löst und diese Lösung durch Gießen, Tauchen, Sprühen oder andere bekannte Auftragstechniken in der gewünschten Schichtstärke auf den Träger aufbringt. Anschließend wird das Lösungsmittel in üblicher Weise entfernt und das photopolymerisierbare Schichtübertragungsmaterial getrocknet. Geeignete Lösungsmittel für das Mischen der Komponenten und Aufbringen des photopolymerisierbaren Schichtübertragungsmaterials auf den Träger sind u.a. niedere Alkohole, Ketone oder Ester, wie z.B. Methanol, Aceton, Methylethylketon, Ethylacetat und ähnliche, sowie Mischungen hiervon. Anschließend kann auf das photopolymerisierbare Schichtübertragungsmaterial gewünschtenfalls noch eine Deckschicht oder Deckfolie aufgebracht werden.

Das erfindungsgemäße photopolymerisierbare Schichtübertragungsmaterial eignet sich in vorteilhafter Weise für die Herstellung von Resistmustern nach den hierfür an sich bekannten und üblichen Verfahren. Hierzu wird das photopolymerisierbare Schichtübertragungsmaterial nach der Schichtübertragung auf das zu schützende Substrat bildmäßig mit aktinischem Licht belichtet, wobei sich hierfür die üblichen Lichtquellen von aktinischem Licht, wie beispielsweise UV-Fluoreszenzröhren, Quecksilberhoch-, -mittel- oder -niederdruckstrahler, superaktinische Leuchtstoffröhren, Xenon-Impulslampen, aber auch UV-Laser, Argonlaser und ähnliche, eignen. Die von den Lichtquellen emittierte Wellenlänge soll im allgemeinen zwischen 230 und 450 nm, bevorzugt zwischen 300 und 420 nm, liegen und insbesondere auf die Eigenabsorption des im photopolymerisierbaren Schichtübertragungsmaterial enthaltenen Photoinitiators abgestimmt sein.

Durch die bildmäßige Belichtung mit dem aktinischen Licht wird in den belichteten Bereichen des Schichtübertragungsmaterials eine Photopolymerisation ausgelöst, die zu einer Vernetzung in den belichteten Schichtbereichen und damit zu einer Löslichkeitsdifferenzierung zwischen den belichteten und unbelichteten Schichtbereichen führt. Nach der bildmäßigen Belichtung wird das Resistmuster durch Auswaschen der unbelichteten, unvernetzten Bereiche des Schichtübertragungsmaterials mit einer wäßrig-alkalischen Entwicklerlösung entwickelt. Das Entwickeln kann durch Waschen, Sprühen, Reiben, Bürsten etc. erfolgen. Als Entwicklerlösungen kommen wäßrig-alkalische Lösungen in Betracht, die zur Einstellung des günstigsten pH-Wertes, im allgemeinen im Bereich von 8 bis 14, vorzugsweise im Bereich von etwa 9 bis 13, alkalisch reagierende Substanzen, wie z.B. Borax, Dinatriumhydrogenphosphat, Soda, Alkalihydroxide oder organische Basen, wie Di- oder Triethanolamin in Wasser gelöst, enthalten. Die wäßrig-alkalischen Entwicklerlösungen können auch Puffersalze, z.B. wasserlösliche Alkaliphosphate, -silikate, -borate, -acetate oder -benzoate enthalten. Als weitere Bestandteile der Entwicklerlösungen können Netzmittel, vorzugsweise anionische Netzmittel, und gegebenenfalls wasserlösliche Polymere, wie z.B. Natriumcarboxymethylcellulose, Polyvinylalkohol, Polynatriumacrylat und dergleichen, mitverwendet werden. Obwohl die erfindungsgemäßen Schichtübertragungsmaterialien im allgemeinen mit rein wäßrig-alkalischen Entwicklerlösungen ausgewaschen werden, ist es selbstverständlich grundsätzlich möglich, wenn auch nicht erforderlich, daß die wäßrig-alkalischen Entwicklerlösungen auch noch geringe zusätze an wasserlöslichen organischen Lösungsmitteln, wie z.B. aliphatischen Alkoholen, Aceton oder Tetrahydrofuran, enthalten.

Die erfindungsgemäßen photopolymerisierbaren Schichtübertragungsmaterialien zeichnen sich durch eine hervorragende Haftung zu metallischen Oberflächen aus. Das hohe Haftungsniveau bleibt auch in wäßrigen Prozeßbädern, insbesondere in den bei der Herstellung von gedruckten Schaltungen üblicherweise verwendeten Plattierlösungen erhalten. Dadurch lassen sich auch feine Bildelemente vorlagengetreu und

sicher reproduzieren. Trotz der guten Haftung wird die Entschichtungszeit des belichteten Schichtübertragungsmaterials durch die erfindungsgemäß einzusetzenden in wäßrig-alkalischer Lösung löslichen tricyclischen heteroaromatischen Verbindungen reduziert. Ein weiterer erheblicher Vorteil der erfindungsgemäß zu verwendenden tricyclischen heteroaromatischen Verbindungen besteht darin, daß die Ausbildung von Restschicht bei Lagerung laminierter metallischer Substrate vollständig verhindert wird.

Die Erfindung wird durch die nachstehenden Beispiele näher erläutert. Die in den Beispielen genannten Teile und Prozente beziehen sich, sofern nicht anders angegeben, auf das Gewicht.

Beispiele 1a und 1b

Zur Herstellung eines Photoresistfilms wurden Gießlösungen durch Mischen der folgenden Komponenten hergestellt:

| | | |
|---|---|---|
| (1) | 37 %ige Lösung (in Methylethylketon/Isopropanol 1/1) eines Copolymeren aus Styrol (24 %), Methylmethacrylat (35 %), Butylacrylat (11 %) und Methacrylsäure (30 %) mit einem K-Wert nach Fikentscher von 51 | 149,80 g |
| (2) | Trimethylolpropantriacrylat | 38,00 g |
| (3) | Sicomet® Patentblau 80E131 | 0,05 g |
| (4) | Ethyl-(p-dimethylamino)benzoat | 3,00 g |
| (5) | Isopropylthioxanthon | 0,50 g |
| (6) | für Beispiel 1a Verbindung der Formel (II) | 0,50 g, |
| | für Beispiel 1b Verbindung der Formel (III) | 0,50 g |

Diese Gießlösungen wurden so auf eine 23 µm starke Polyethylenterephthalatfolie aufgebracht, daß nach dem Ablüften und Trocknen (90 °C, 5 Minuten) eine Trockenschichtdicke der photopolymerisierbaren Schicht von 38 µm resultierte. Die photopolymerisierbaren Schichten wurde mit einer 30 µm starken Polyethylenfolie abgedeckt. Danach wurde der Folienverbund aus Polyesterfolie, photopolymerisierbarer Schicht und Polyethylenfolie auf eine Rolle gewickelt. Zur Prüfung wurde die Polyethylenfolie abgezogen und der Resistfilm mit der photoempfindlichen Schicht zum Kupfer auf die kupferkaschierte oberfläche eines Leiterplattensubstrats übertragen (105 °C, 1,5 m/Minute). Danach wurde die Resistschicht in einem Riston® PC-Printer (Hersteller: E.I: Du Pont de Nemours) durch ein Testnegativ belichtet. Nach der Belichtung wurde die Polyesterfolie abgezogen und der Resist 30 Sekunden in 1 %iger Sodalösung entwickelt.

Zur permanenten Strukturierung des Leiterplattensubstrats wurde dieses nach den üblichen Vorbehandlungsschritten wie Reinigung und Anätzen in ein Zinnbad eingebracht, und an den nicht vom Resist geschützten Teilen der Metalloberfläche eine 38 µm starke Zinnschicht galvanisch abgeschieden. Danach wurde der belichtete Resist in 3 %iger KOH-Lösung bei 50 °C entfernt, wobei bis zur vollständigen Entfernung des Resists 35 Sekunden nötig waren. Die Kantenschärfe der galvanisch abgeschiedenen Leiterbahnen wurde dann unter einem Mikroskop nach folgender Notenskala beurteilt:

| Note | Beurteilung |
|---|---|
| 1 | scharfe Kanten |
| 2 | an einzelnen Stellen unruhige Kanten, an denen der Resist bis zu 5 µm unterwandert ist |
| 3 | auf der gesamten Leiterplatte unruhige Kanten, an denen der Resist bis zu 5 µm unterwandert ist |
| 4 | Unterwanderungen > 5 µm |
| 5 | Kurzschlüsse zwischen benachbarten Leiterbahnen |

In beiden Fällen wurde die Kantenschärfe mit Note 1 beurteilt.

Zur Restschichtprüfung wurden die Resiste auf Leiterplattensubstrate laminiert und 10 Tage bei 27° C und 65 % relativer Luftfeuchte gelagert. Danach wurde entwickelt und angeätzt. Die Restschicht wurde gemessen als der Anteil der Oberfläche (in %), der nicht mehr angeätzt werden kann. Die Resiste der Beispiele 1a und 1b wiesen unter den angegebenen Bedingungen keine Restschicht auf.

Vergleichsbeispiel

Beispiel 1a wurde wiederholt, jedoch wurde auf den Zusatz der erfindungsgemäßen Verbindungen der Formel (II) bzw. (III) verzichtet. Die Prüfung erfolgte wie in Beispiel 1. Dabei wurden folgende Ergebnisse erhalten:

Entschichtungszeit: 50 Sekunden

Kantenschärfe: Note 5

Restschicht: 100%

## Ansprüche

1. Photopolymerisierbares Schichtübertragungsmaterial, bestehend aus
(a) mindestens einem filmbildenden Polymerisat als Bindemittel, (b) mindestens einer mit dem Bindemittel verträglichen organischen Verbindung mit mindestens zwei zur Additionspolymerisation befähigten Doppelbindungen, die gegebenenfalls teilweise durch eine organische Verbindung mit nur einer zur Additionspolymerisation befähigten Doppelbindung ersetzt sein kann,
(c) einem Photoinitiator oder Photoinitiatorsystem,
(d) einem Haftungsvermittler und
(e) gegebenenfalls üblichen Zusatz- und Hilfsstoffen,
dadurch gekennzeichnet, daß als Haftungsvermittler (d) eine tricyclische heteroaromatische Verbindung, die in wäßrig-alkalischer Lösung löslich ist, eingesetzt wird.

2. Schichtübertragungsmaterial nach Anspruch 1, dadurch gekennzeichnet, daß es in wäßrig-alkalischen Lösungen entwickelt werden kann.

3. Schichtübertragungsmaterial nach Anspruch 1, dadurch gekennzeichnet, daß die als Haftungsvermittler verwendete tricyclische heteroaromatische Verbindung in einer 1 gew.%igen wäßrigen Natriumcarbonat-Lösung bei 25° C eine Löslichkeit von mindestens 0,05 Gew.% aufweist.

4. Schichtübertragungsmaterial nach Anspruch 1, dadurch gekennzeichnet, daß als Haftungsvermittler (d) eine Verbindung der allgemeinen Formel (I)

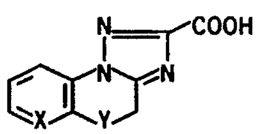

(I),

worin X für CH oder H, Y für O, S oder $NR^1$ und $R^1$ für H, Alkyl oder Aryl stehen, oder einer damit tautomeren Formel davon eingesetzt wird.

5. Schichtübertragungsmaterial nach einem der vorhergehenden Ansprüche, dadurch gekennzeichnet, daß als Haftungsvermittler (d) eine Verbindung der Formeln

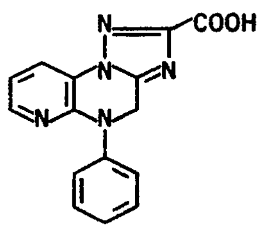

und/oder

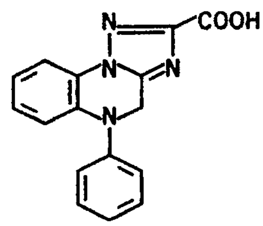

eingesetzt wird.

6. Schichtübertragungsmaterial nach Anspruch 1, dadurch gekennzeichnet, daß als Bindemittel ein Copolymerisat aus mindestens einem sauren Monomer und mindestens einem hydrophoben Monomer verwendet wird.

7. Schichtübertragungsmaterial nach Anspruch 6, dadurch gekennzeichnet, daß als saures Monomer Acrylsäure oder Methacrylsäure verwendet wird.

8. Schichtübertragungsmaterial nach Anspruch 6 oder 7, dadurch gekennzeichnet, daß die hydrophoben Monomeren aus der Gruppe der Acrylate, Methacrylate und Styrole ausgewählt werden.